# EUROPEAN PATENT APPLICATION

(11) **EP 1 883 147 A2**
(43) Date of publication of application: **30.01.2008**
(21) Application number: 07013386.3
(22) Date of filing: 09.07.2007
(51) Int. Cl.: H02K 5/22, H02K 5/10

(54) **Seal structure for electric circuit unit**

(30) Priority: 24.07.2006 JP 2006201311
(71) Applicant: Fanuc Ltd, Minamitsuru-gun, Yamanashi 401-0597 (JP)
(72) Inventor: Taniguchi, Mitsuyuki, Gotenba-shi, Shizuoka 412-0045 (JP); Imai, Keisuke, Minamitsuru-gun Yamanashi 401-0301 (JP); Nagamoto, Ichirou, Toda-shi, Saitama 335-0015 (JP)
(74) Representative: Thum, Bernhard

(57) **Abstract**

A seal structure for an electric circuit unit is formed of an elastic material and includes an annular seal member mounted between an inner peripheral surface of an opening formed in a casing to pass a cable therethrough and an outer peripheral surface of the cable, a fixed member fixed on the casing at the opening, and a size-changing member formed with a through hole for allowing the cable to pass therethrough and adapted to change the size of the opening of the casing so as to fit the size of the outer periphery of the cable. The size-changing member is fixed in the opening, so that the fixed member is deformed by being held between the size-changing member and the fixed member, thereby bringing the seal member into close contact with the inner peripheral surface of the opening of the casing and the outer peripheral surface of the cable.

## Description

### BACKGROUND OF THE INVENTION

### 1. Field of the Invention

The present invention relates to a seal structure for an electric circuit unit comprising an electric circuit, a casing for protecting the electric circuit and a cable connected to the electric circuit.

### 2. Description of the Related Art

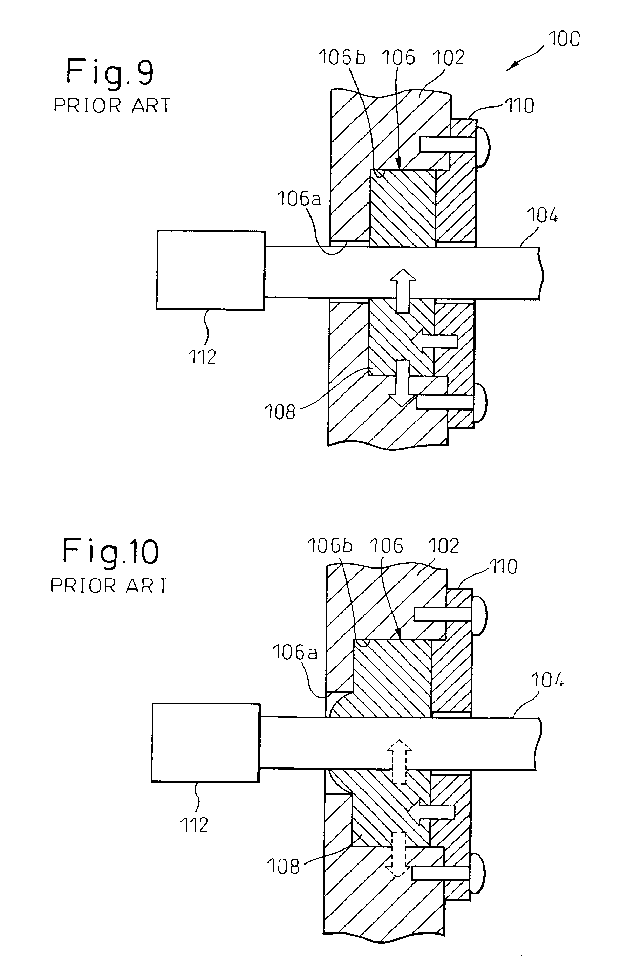

An electric circuit unit is comprised of an electric circuit, a casing for protecting the electric circuit and a cable connected to the electric circuit for inputting and outputting a signal and supplying electric power. For the purpose of fixing and waterproofing the cable, a seal structure 100 as shown in Fig. 9 is generally used in a portion of the casing through which the cable passes from the outside to the inside of the casing. Specifically, the casing 102 is formed with a stepwise opening 106 for passing a cable 104 therethrough, in which the opening includes a small-diameter portion 106a and a large-diameter portion 106b, and an annular seal member 108 formed of an elastic material, such as a rubber bushing is mounted around the cable in the large-diameter portion 106b of the opening 106 and pressure is exerted on the seal member 108 by a fixed member 110. The seal member 108 is formed of an elastic material, and therefore, under pressure from the fixed member 110, deformed between the fixed member 110 and a shoulder defined between the small-diameter portion 106a and the large-diameter portion 106b. Thus, the inner periphery of the seal member 108 is reduced in size and closely contacts the outer peripheral surface of the cable 104, while the outer periphery of the seal member 108 is expanded and closely contacts the inner peripheral surface of the large-diameter portion 106b of the opening 106. As a result, the seal member 108 can seal a gap between the inner peripheral surface of the opening 106 of the casing 102 and the outer peripheral surface of the cable 104. Also, the seal member 108, under pressure from the fixed member 110, is kept pressed against the inner peripheral surface of the opening 106 and the outer peripheral surface of the cable 104. Therefore, even if the cable 104 is bent or displaced under external force, the seal member 108 can follow the behavior of the cable 104 and maintain a seal.

Japanese Unexamined Patent Publication No. 2003-274597 discloses a detector cable outlet structure for a motor, which uses a principle similar to that of the seal structure described above. In the detector cable outlet structure disclosed in Japanese Unexamined Patent Publication No. 2003-274597, though different in the shape of the seal member from the aforementioned seal structure, the seal member is deformed by exerting pressure on the seal member as in the aforementioned seal structure to secure the waterproofness of the cable holes.

In the electric circuit unit, the cable 10 and the electric circuit are often connected to each other using a connecting member 112, such as a connector in order to improve convenience of assembly, and this connecting member 112 generally has an outer periphery size larger than the cable 104. However, in the seal structure described above, the small-diameter portion 106a of the opening 106 is generally formed to have a diameter slightly larger than that of the cable 104, and in such a case, the connecting member 112 cannot pass through the small-diameter portion 106a of the opening 106. Therefore, before the connecting member 112 is mounted on the cable 104, it is necessary to insert the cable 104 through the opening 106 and then attach, in the narrow casing 102, the connecting member 112 to the forward end of the cable 104. This deteriorates the work efficiency. Also, in view of the fact that the cable 104, the connecting member 112 and the fixed member 110 cannot be assembled in advance and placed in stock as a subassembly, the connecting member 112 is required to be attached to the cable 104 while assembling the electric circuit unit. Therefore, the assembly step lacks flexibility.

If the size of the small-diameter portion 106a of the opening 106 is increased to such a degree as to allow the connecting member 112 to pass therethrough, the connecting member 112 and the cable 104 could be inserted through the opening 106 and assembled to the casing 10 after attaching the connecting member 112 to the cable 104. However, in such a case, as shown in Fig. 10, deformation pressure would escape into the gap between the inner peripheral surface of the small-diameter portion 106a of the opening 106 and the outer peripheral surface of the cable 104 when pressure is exerted on the seal member 108 by the fixed member 110. Thus, pressure could not be efficiently exerted on the inner peripheral surface of the opening 106 and the outer peripheral surface of the cable 104 in order to bring the seal member 108 into close contact, thereby making it difficult to secure a sufficient seal.

### SUMMARY OF THE INVENTION

Accordingly, an object of the present invention is to provide a seal structure for an electric circuit unit which can secure a sufficient seal and facilitate assembly work regardless of the size of the cable-passing opening formed in the casing of the electric circuit unit.

In order to achieve this object, according to the present invention, there is provided a seal structure for an electric circuit unit, which includes an annular seal member formed of an elastic material and mounted between an inner peripheral surface of an opening formed to pass a cable through a casing of the electric circuit unit and an outer peripheral surface of the cable, and a fixed member fixed to the casing at the opening, the seal member being deformed in the opening by the fixed member pressing the sealing member thereby to seal a gap between the inner peripheral surface of the opening and the outer peripheral surface of the cable, wherein the seal structure further includes a size-changing member formed with a through hole for allowing the cable to pass therethrough, the size-changing member adapted to change the size of the opening of the casing so as to fit to the size of the outer periphery of the cable, the size-changing member arranged or fixed in the opening, so that the seal member is deformed by being held between the size-changing member thus arranged or fixed and the fixed member, thereby bring the seal member into close contact with the inner peripheral surface of the opening of the casing and the outer peripheral surface of the cable.

In the seal structure for the electric circuit unit described above, the through hole of the size-changing member preferably has a cross section of substantially the same shape as that of the outer periphery of the cable, and the size-changing member preferably has an outer periphery of substantially the same shape as that of the cross section of the opening.

A connecting member having an outer periphery larger than the cable may be attached to the forward end of the cable, and the opening of the casing may be formed to allow the connecting member to pass through the opening of the casing.

In one embodiment, the opening of the casing includes a small hole portion having an outer periphery larger than that of the connecting member and smaller than that of the size-changing member and a large hole portion having an outer periphery larger than the size-changing member, so that the size-changing member can be arranged or fixed in the opening by being brought into contact with a shoulder formed between the small hole portion and the large hole portion.

In another embodiment, the size-changing member may be fixed in the opening by joining the outer peripheral surface of the size-changing member to the inner peripheral surface of the opening.

In the seal structure for the electric circuit unit according to the present invention, the seal member and the size-changing member are preferably integrated with each other.

The seal structure according to the present invention includes the size-changing member for changing the size of the opening of the casing of the electric circuit unit to fit to the size of the outer periphery of the cable. Therefore, by fixing the size-changing member in the opening of the casing and holding, pressing and thus deforming the seal member between the size-changing member and the fixed member, a sufficient seal can be secured regardless of the size of the opening. Further, in view of the fact that the seal is not affected by the size of the opening, the opening of the casing can be designed in a sufficient size to allow the cable, having the connecting member such as a connector connected at the forward end thereof, to pass through the opening. As a result, the work of assembling the electric circuit unit can be simplified, thereby reducing work time.

### BRIEF DESCRIPTION OF THE DRAWINGS

The above and other objects, features and advantages of the present invention will be described in more detail below based on preferred embodiments of the present invention with reference to the accompanying drawings, in which:
Fig. 1 is an enlarged sectional view of a substantial part of a seal structure for an electric circuit unit according to a first embodiment of the present invention;
Fig. 2 is an exploded view of the substantial part of the seal structure according to the first embodiment shown in Fig. 1;
Fig. 3 is an enlarged sectional view of a substantial part of a seal structure for an electric circuit unit according to a second embodiment of the present invention;
Fig. 4 is an enlarged sectional view showing a size-changing member and a seal member integral with each other used in a seal structure for an electric circuit unit according to a third embodiment of the present invention;
Fig. 5 is an enlarged sectional view of the substantial part of the seal structure for the electric circuit unit using the size-changing member and the seal member integral with each other shown in Fig. 4 according to the third embodiment of the present invention;
Fig. 6 is a plan view showing an example of the cross-sectional shape of the size-changing member and seal member;
Fig. 7 is a plan view showing another example of the cross-sectional shape of the size-changing member and seal member;
Fig. 8 is a schematic diagram showing an overall configuration of the electric circuit unit using the seal structure according to the present invention;
Fig. 9 is an enlarged sectional view of a substantial part of a conventional seal structure; and
Fig. 10 is an enlarged sectional view showing a variation of the substantial part of the conventional seal structure.

### DETAILED DESCRIPTION

Several embodiments of a seal structure for an electric circuit unit according to the present invention will be described below with reference to the drawings.

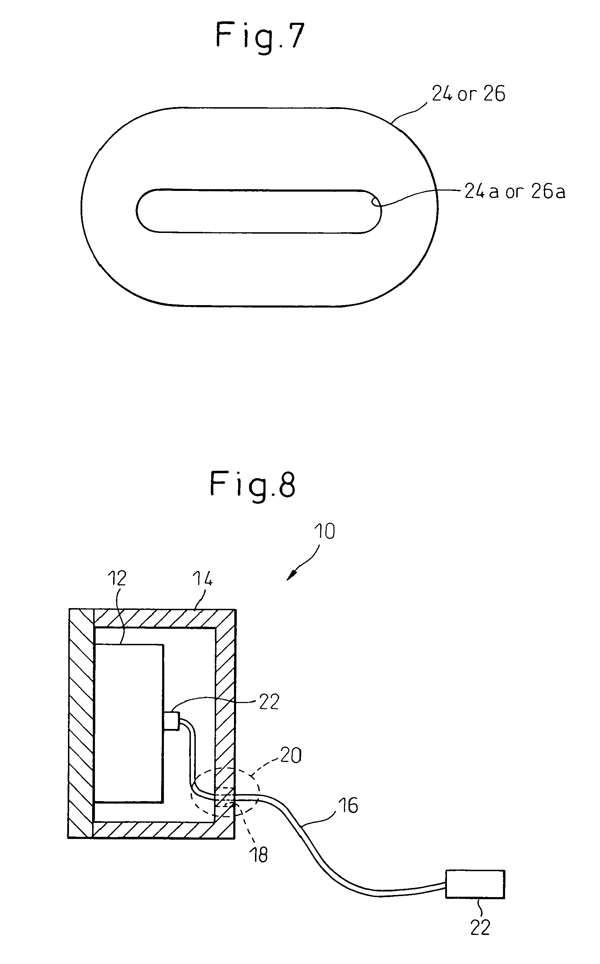

First, referring to Fig. 8, an overall configuration of an electric circuit unit 10 using a seal structure according to the present invention will be described. The electric circuit unit 10 is configured of an electric circuit 12, a casing 14 for protecting the electric circuit 12 and a cable 16 connected to the electric circuit 12 for inputting and outputting a signal and supplying electric power. The casing 14 is formed with an opening 18 through which the cable 16 passes from the outside to the inside of the casing 14, and a seal structure 20 is provided at the opening for sealing the inside of the casing 14 from the outside of the casing 14. Further, a connecting member 22, such as a connector to facilitate connection between the cable 16 and the electric circuit 12 or an external device (not shown) is attached to each end of the cable 16.

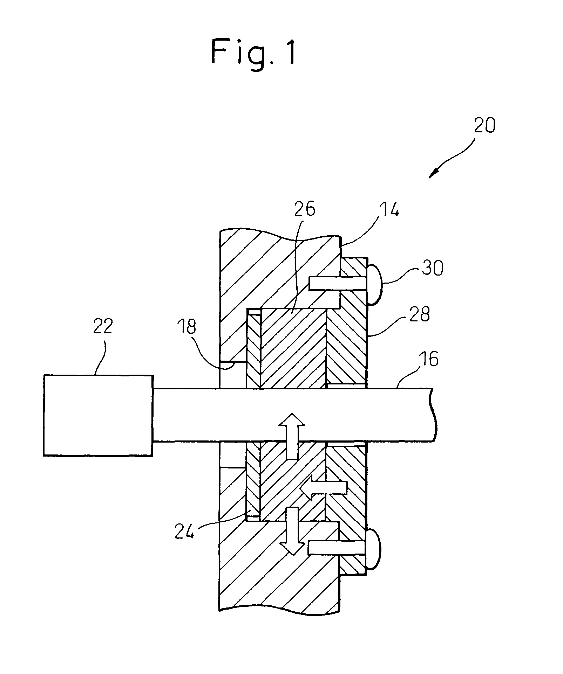

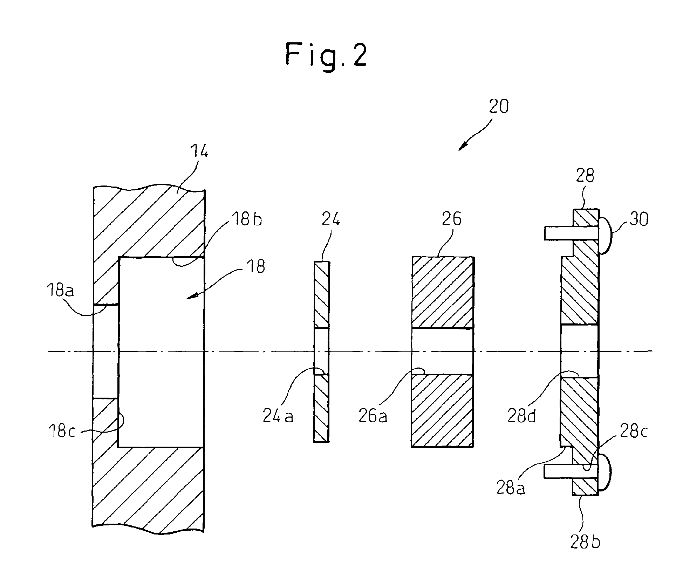

Figs. 1 and 2 show a substantial part of a seal structure 20 according to a first embodiment of the present invention. The seal structure 20 includes a size-changing member 24, a seal member 26 formed of an elastic material and a fixed member 20. The size-changing member 24 and fixed member 28 are formed of a rigid material having a sufficient stiffness to elastically deform the seal member 26 as described later. The opening 18 formed in the casing 14 is configured of a small-diameter portion 18a having a smaller cross-sectional area, a large-diameter portion 18b having a larger cross-sectional area than the small-diameter portion 18a, and an annular shoulder 18c formed between the small-diameter portion 18a and the large-diameter portion 18b. The small-diameter portion 18a has an outer periphery of a size larger than that of the connecting member 22 so as to allow the connecting member 22 to pass therethrough and smaller than that of the size-changing member 24 so as not to allow the size-changing member 24 to pass therethrough. Also, the outer periphery of the large-diameter portion 18b is larger than that of the size-changing member 24.

The size-changing member 24 is intended to change the size of the opening 18 of the casing 14 so as to fit to the size of the outer periphery of the cable 16 and is arranged and fixed in contact with the shoulder 18c in the large-diameter portion 18b of the opening 18 of the casing 14. The size-changing member 24 may have any outer periphery of a suitable shape and size as long as if it can be accommodated in the large-diameter portion 18b of the opening 18 but cannot passage through the small-diameter portion 18a of the opening 18. However, a gap, into which the seal member 26 can be intruded when it is deformed in the large-diameter portion 18b, would lead to consumption of a part of deformation pressure acting on the seal member 26 to deform the seal member 26 into the gap, thereby making it impossible for deformation pressure to act efficiently in a diametrical direction. Therefore, in order to prevent such a gap from being formed, the size-changing member 24 preferably has the outer periphery of a shape and size substantially the same as or slightly smaller than the large-diameter portion 18b.

Further, the size-changing member 24 is formed at the central portion thereof with a through hole 24a for allowing the cable 16 to pass therethrough. The through hole 24a of the size-changing member 24 can have an appropriate size as long as it allows the cable 16 to pass therethrough. However, it preferably has a cross-sectional shape and size substantially the same as or slightly smaller than those of the outer periphery of the cable 16. The fact that the through hole 24a of the size-changing member 24 has a cross-section shape and size substantially same as or slightly smaller than those of the outer periphery of the cable 16 can prevent the formation of a gap which allows a deformed seal member 26 to intrude therein, thereby making it possible for deformation pressure to act efficiently in a diametrical direction.

The seal member 26 is arranged in the large-diameter portion 18b of the opening 18 of the casing 14 so as to be held between the size-changing member 24 and the fixed member 28, and is adapted to be pressed by the fixed member 28 and deformed in a diametrical direction in the large-diameter portion 18b of the opening 18 when pressure is exerted. The seal member 26 may have the outer periphery of an appropriate shape and size as long as it allows the seal member 26 to be accommodated in the large-diameter portion 18b of the opening 18 of the casing 14. However, it preferably has the outer periphery of a shape and size substantially the same as or slightly smaller than those of the cross section of large-diameter portion 18b of the opening 18. Also, the seal member 26 has an annular shape and is formed at the central portion thereof with a through hole 26a for allowing the cable 16 to pass therethrough. The through hole 26a of the seal member 26 may have a cross section of an appropriate shape and size as long as it allows the cable 16 to pass therethrough. However, it preferably has a cross section of a shape and size substantially the same as or slightly smaller than those of the outer periphery of the cable 16.

In a case where the seal member 26 has the outer periphery of a shape and size substantially the same as or slightly smaller than those of the cross section of the large-diameter portion 18b of the opening 18 and the through hole 26a of the seal member 26 has the cross section of a shape and size substantially the same as or slightly larger than those of the outer periphery of the cable 16, the seal member 26 can be brought into close contact with the inner peripheral surface of the large-diameter portion 18b of the opening 18 and the outer peripheral surface of the cable 16 just by being slightly deformed under light pressure, thereby securing a sufficient seal.

The fixed member 28 includes a fitting portion 28a to be fitted in the large-diameter portion 18b of the opening 18 of the casing 14 and a flange portion 28b extending in a diametrical direction from the outer periphery of the fitting portion 28a. The flange portion 28b is formed with a plurality of mounting holes 28, and the fixed member 28 is fixed to the casing 14 by fasteners 30, such as screws or rivets inserted through the mounting holes 28c. When the fixed member 28 is fixed to the casing 14, the fitting portion 28a is fitted in the large-diameter portion 18b of the opening 18 and presses and deforms the seal member 26. Also, the fixed member 28 is formed at the center thereof with a through hole 28d for allowing the cable 16 to pass therethrough. The through hole 28d of the fixed member 28 may have the cross section of an appropriate shape and size as long as it allows the cable 16 to pass therethrough. However, it preferably has the cross section of a shape and size substantially the same as or slightly larger than those of the outer periphery of the cable 16. As described above, the configuration in which the through hole 28d of the fixed member 28 has the cross section of the shape and size substantially same as those of the outer periphery of the cable 16 makes it possible for pressure to efficiently act on the seal member 26. Therefore, a sufficient seal can be secured.

In assembling the seal structure 20 shown in Figs. 1 and 2, first, the cable 16 is passed through the through hole 28d of the fixed member 28, the through hole 26a of the seal member 26 and the through hole 24a of the size-changing member 24, and the connecting member 22 such as a connector is then attached to the forward end of the cable 16 thereby to complete a subassembly in advance. Next, the connecting member 22 is inserted into the casing 14 through the small-diameter portion 18a of the opening 18 of the casing 14, and is connected to the electric circuit 12 in the casing 14. The size-changing member 24 is then brought into contact with the shoulder 18c of the opening 18 and fixed in the opening 18, and the fixed member is fixed to the casing 14 by means of fasteners 30, such as screws or rivets so as to hold the seal member 26 between the fixed size-changing member 24 and the fixed member 28. In the process, the seal member 26 is pressed by the fixed member 28 and deformed into close contact with the outer peripheral surface of the cable 16 and the inner peripheral surface of the large-diameter portion 18b of the opening 18. As a result, the gap between the outer peripheral surface of the cable 16 and the inner peripheral surface of the large-diameter portion 18b of the opening 18 is sealed.

Since the presence of the size-changing member 24 makes it possible to design the opening 18 of the casing 14 to have a sufficient size to allow the connecting member 22 to pass therethrough, as described above, the cable 16 can be inserted through the opening 18 of the casing 14 even with the connecting member 22 attached to the forward end of the cable 16. Therefore, a subassembly can be prepared in advance by passing the cable 16 through the size-changing member 24, the seal member 26 and the fixed member 28 and attaching the connecting member 22 to the forward end of the cable 16. This can eliminate the work of attaching the connecting member 22 to the forward end of the cable 16 within the narrow inner space of the casing 14 and simplify the attaching work required to do on site. Further, even in the case where the cross section of the small-diameter portion 18a of the opening 18 is so large that a large gap is left between the inner peripheral surface 18a of the small-diameter portion 18a and the outer peripheral surface of the cable 16, the size-changing member 24 blocks at least part of the inlet to the gap to prevent the deformed seal member 26 from intruding through the inlet into the small-diameter portion 18a. As a result, the pressure exerted on the seal member 26 by the fixed member 28 is efficiently converted into the deformation force in such a direction as to bring the seal member 26 into contact with the outer peripheral surface of the cable 16 in the large-diameter portion 18b and the inner peripheral surface of the opening 18, thereby making it possible to secure a sufficient sealability.

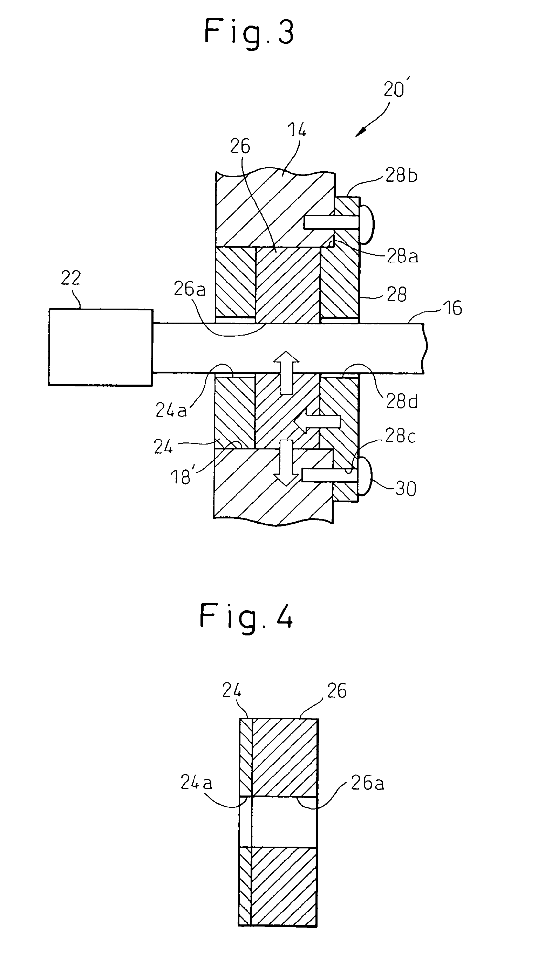

Next, referring to Fig. 3, a seal structure according to a second embodiment of the present invention will be described. The seal structure 20' according to the second embodiment is different from the seal structure 20 according to the first embodiment in that a casing 14 of an electric circuit unit 10 is formed with a linear opening 18' having no shoulder, unlike the stepwise opening 18. The opening 18' has a cross-sectional area sufficiently large to allow the connecting member 22 attached to the forward end of the cable 16 to pass therethrough. The size-changing member 24 is fixed in the opening 18' by means of joining, such as welding, bonding or caulking, and the seal member 26 is held and pressed between the fixed size-changing member 24 and the fixed member 28 fixed on the casing 14. The other features are similar to those of the seal structure according to the first embodiment and therefore the description thereof is omitted here.

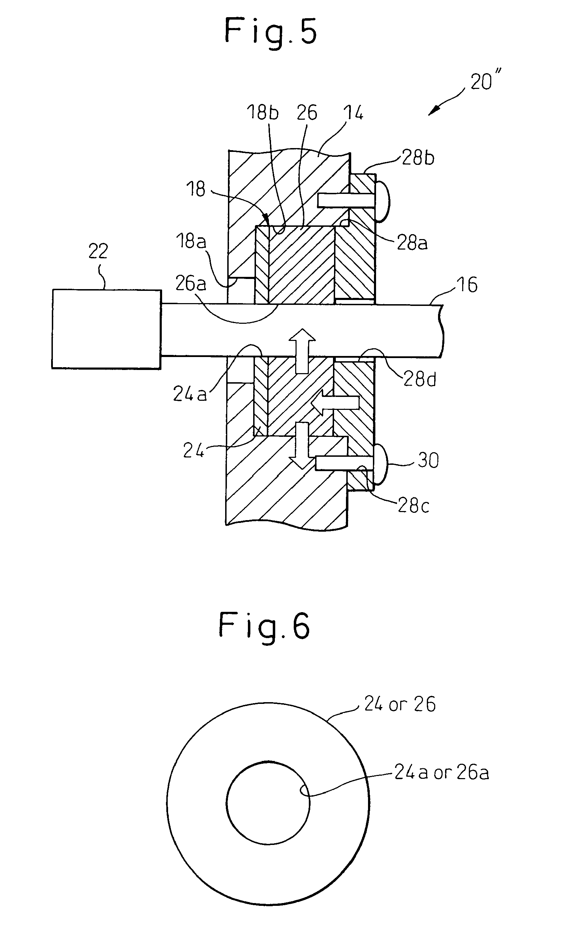

Figs. 4 and 5 show a seal structure according to a third embodiment of the present invention. The seal structure 20" according to the third embodiment is different from the seal structure 20 according to the first embodiment in that a size-changing member 24 and a seal member 26 are integrated with each other as seen best in Fig. 4. This third embodiment is advantageous in that the number of the parts of the seal structure 20" can be effectively reduced. The other structures and operations are similar to those of the seal structure 20 according to the first embodiment and therefore the description thereof is omitted here.

In the above embodiments, each of the size-changing member 24 and seal member 26 preferably has a cross section of a disk-like shape formed with an opening, as shown in Fig. 6. However, the size-changing member 24 and seal member 26 may have an outer periphery or through hole cross section of a non-circular shape as shown in Fig. 7, in accordance with the cross-sectional shapes of the opening 18, 18' and the cable 16.

## Claims

1. A seal structure (20; 20'; 20") for an electric circuit unit (10), comprising an annular seal member (26) formed of an elastic material and mounted between an inner peripheral surface of an opening (18; 18') formed to pass a cable (16) through a casing (14) of the electric circuit unit (10) and an outer peripheral surface of the cable (16), and a fixed member (28) fixed on the casing (14) at the opening (18; 18'), said seal member (26) being deformed in the opening by the fixed member (28) pressing the seal member (26) thereby to seal a gap between the inner peripheral surface of the opening (18; 18') and the outer peripheral surface of the cable (16), said seal structure **characterized in that** the seal structure further comprises a size-changing member (24) formed with a through hole (24a) for allowing the cable (16) to pass therethrough, said size-changing member (24) adapted to change the size of the opening (18; 18') of the casing (14) so as to fit to the size of the outer periphery of the cable (16), said size-changing member (24) arranged or fixed in the opening (18; 18'), so that the seal member (26) is deformed by being held between the size-changing member (24) thus arranged or fixed and the fixed member (28), thereby bringing the seal member (26) into close contact with the inner peripheral surface of the opening (18; 18') of the casing (14) and the outer peripheral surface of the cable (16).

2. The seal structure for the electric circuit unit according to claim 1, wherein the through hole (24a) of the size-changing member (24) has the cross section of substantially the same shape as that of the outer periphery of the cable (16), and the size-changing member (24) has an outer periphery of substantially the same shape as that of the cross section of the opening (18; 18').

3. The seal structure for the electric circuit unit according to claim 1, wherein a connecting member (22) having an outer periphery larger than the cable (16) is attached to the forward end of the cable (16), and the opening (18; 18') of the casing (14) is formed to allow the connecting member (22) to pass through the opening (18; 18') of the casing (14).

4. The seal structure for the electric circuit unit according to claim 3, wherein the opening (18) of the casing (14) includes a small hole portion (18a) having an outer periphery larger than that of the connecting member (22) and smaller than that of the size-changing member (24) and a large hole portion (18b) having an outer periphery larger than the size-changing member (24), so that the size-changing member (24) can be arranged or fixed in the opening (18) by being brought into contact with a shoulder (18c) formed between the small hole portion (18a) and the large hole portion (18b) .

5. The seal structure for the electric circuit unit according to claim 3, wherein the size-changing member (24) is fixed in the opening (18') by joining the outer peripheral surface of the size-changing member (24) to the inner peripheral surface of the opening (18').

6. The seal structure for the electric circuit unit according to any one of claims 1 to 5, wherein the seal member (26) and the size-changing member (24) are integrated with each other.
